# EUROPEAN PATENT APPLICATION

(11) **EP 2 211 206 A1**
(43) Date of publication of application: **28.07.2010**
(21) Application number: 09004833.1
(22) Date of filing: 01.04.2009
(51) Int. Cl.: G02B 3/00, G02B 5/00, H01L 33/00

(54) **Optical lens structure**

(30) Priority: 23.01.2009 TW 98102942
(71) Applicant: Everlight Electronics Co., Ltd., Tucheng T'ai pei (TW)
(72) Inventor: Chiang, Jen-Ta, Tucheng T'ai pei (TW); Liang, Chia-Hao, Tucheng T'ai pei (TW)
(74) Representative: Becker Kurig Straus

(57) **Abstract**

An optical lens structure is disclosed. The optical lens structure is suitable to cover a light emitting source, wherein the light emitting source is suitable to provide an illumination light. The optical lens structure includes a trench structure and two optical light-emitting surfaces. The two optical light-emitting surfaces are located at both sides opposite to each other of the trench structure and physically connect the trench structure. The illumination light from the light emitting source is transmitted from the optical light-emitting surfaces to a direction far away from the light emitting source.

## Description

### BACKGROUND OF THE INVENTION

### 1. Field of the Invention

The present invention generally relates to a lens structure, and more particularly, to a side-emitting optical lens structure.

### 2. Description of Related Art

Along with the increasing progress of semiconductor science and technology, the light emitting diode (LED) today has many advantages, such as high luminance output, low power consumption, small size, low driving voltage and mercury-free content. Therefore, LEDs are broadly applied in display and illumination fields.

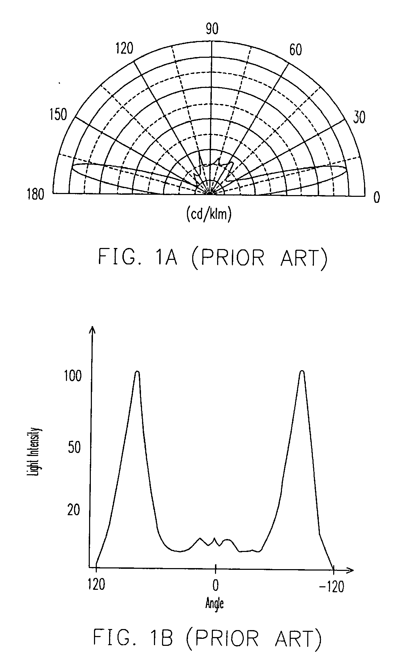

In general, a conventional side-emitting optical lens structure together with LEDs would provide light with a light-radiation pattern as shown by Figs. 1A and 1B. Fig. 1A is a light-radiation pattern graph corresponding to a radiation angle scope between 0° and 180° of a conventional side-emitting optical lens structure and Fig. 1B is a spectrogram corresponding to a radiation angle scope between -120° and 120° of a conventional side-emitting optical lens structure.

In Figs. 1A and 1B, LEDs usually serve as a light source, so that the LEDs in association with a side-emitting optical lens structure are able to side-emit light, which is applicable in scene illumination and the like. However, the light-radiation pattern produced by the above-mentioned conventional optical lens structure can not reduce the light intensity distributed on the middle domain (for example, the middle domain roughly between -60 ° and 60 °, as shown in Fig. 1B) to the minimum (for example, approaching zero), so that the above-mentioned optical lens structure can not produce a better effect for the scene illumination. In addition, the above-mentioned fails to produce a desired asymmetrical light-radiation pattern.

Based on the described above, how to design an optical lens structure capable of effectively reducing the light intensity distributed on the middle domain so as to better suit a scene illumination and making the saved radiant light flux transferred to the side angle scopes so as to enhance the side-emitting light intensity is an important project.

### SUMMARY OF THE INVENTION

Accordingly, the present invention is directed to an optical lens structure, which in association with a light emitting source can produce a better side-emitting light-radiation pattern.

The present invention provides an optical lens structure, which is suitable to cover a light emitting source, wherein the light emitting source is substantially disposed on a virtual plane and the light emitting source is suitable to provide an illumination light. The optical lens structure includes a trench structure and two optical light-emitting surfaces. The orthogonal projection of the trench structure on the virtual plane splits the orthogonal projection of the optical lens structure on the virtual plane into two portions. The light emitting source is located on the orthogonal projection of the trench structure on the virtual plane. The two optical light-emitting surfaces are located at both sides opposite to each other of the trench structure and physically connect the trench structure. The illumination light from the light emitting source is transmitted from the optical light-emitting surfaces to a direction far away from the light emitting source.

In an embodiment of the present invention, the orthogonal projection of the trench structure on the virtual plane is located on the symmetrical axis of the orthogonal projection of the optical lens structure on the virtual plane.

In an embodiment of the present invention, the illumination light from the light emitting source is totally reflected by the trench structure to the optical light-emitting surfaces.

In an embodiment of the present invention, the trench structure substantially does not expose the light emitting source.

In an embodiment of the present invention, the width of the trench structure is substantially between 0.0 1 mm and 1mm.

In an embodiment of the present invention, the light emitting source is a light emitting diode chip.

In an embodiment of the present invention, the material of the optical lens structure is a transparent material.

In an embodiment of the present invention, the light emitting source is a light emitting device and the light emitting device includes a light emitting diode chip and an encapsulant, wherein the light emitting diode chip is disposed in the encapsulant.

In an embodiment of the present invention, the material of the encapsulant is a transparent material.

In an embodiment of the present invention, the transparent material is polymethyl methacrylate (PMMA) or polycarbonate (PC).

In an embodiment of the present invention, the optical lens structure has a trench structure and the trench structure is located between two optical light-emitting surfaces, so that the light emitting source disposed in the optical lens structure can produce a better light-radiation pattern, with which the light from the light emitting source can be emitted from the two optical light-emitting surfaces only. In this way, the problem with the conventional optical lens structure that a certain extent of the light intensity distributed on the middle domain can be solved, and a light emitting source in association with the optical lens structure of the present invention can produce a better side-emitting light-radiation pattern to contribute a better performance in the scene illumination field.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1A is a light-radiation pattern graph corresponding to a radiation angle scope between 0° and 180° of a conventional side-emitting optical lens structure.

Fig. 1B is a spectrogram corresponding to a radiation angle scope between -120° and 120° of a conventional side-emitting optical lens structure.

Fig. 2A is a 3-dimensional diagram of an optical lens structure according to an embodiment of the present invention.

Fig. 2B is a top-projection diagram of the optical lens structure of Fig. 2A.

Fig. 2C is a cross-sectional diagram of the optical lens structure of Fig. 2A along line AA'.shown in Fig. 2B.

Fig. 3 is a light-radiation distribution graph generated by a light emitting source together with an optical lens structure provided by the present invention.

Fig. 4 is a 3-dimensional diagram of a light emitting source according to another embodiment of the present invention.

Fig. 5 is a 3-dimensional diagram of an optical lens module according to an embodiment of the present invention.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

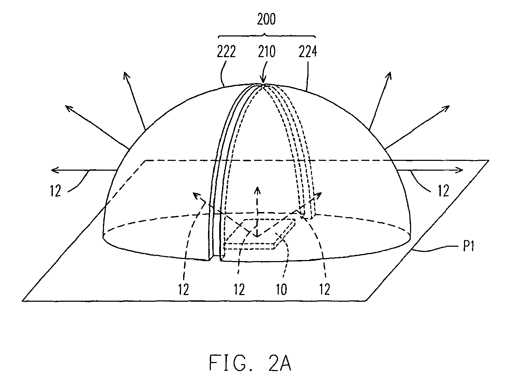

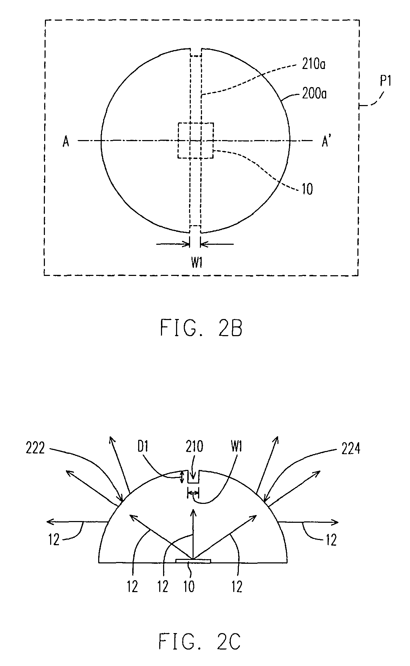

Fig. 2A is a 3-dimensional diagram of an optical lens structure according to an embodiment of the present invention, Fig. 2B is a top-projection diagram of the optical lens structure of Fig. 2A and Fig. 2C is a cross-sectional diagram of the optical lens structure of Fig. 2A along line AA'.shown in Fig. 2B. Referring to Figs. 2A to Fig. 2C, an optical lens structure 200 of the embodiment is suitable to cover a light emitting source 10, wherein the light emitting source 10 is substantially disposed on a virtual plane P1 and the light emitting source 10 is suitable to provide an illumination light 12, as shown by Fig. 2A.

The optical lens structure 200 includes a trench structure 210 and two optical light-emitting surfaces 222 and 224. The orthogonal projection 210a of the trench structure 210 on the virtual plane P1 splits the orthogonal projection 200a of the optical lens structure 200 on the virtual plane P1 into two portions, as shown by Figs. 2A and 2B. The light emitting source 10 is located on the orthogonal projection 210a of the trench structure 210 on the virtual plane P1.

In the embodiment, the orthogonal projection 210a of the trench structure 210 on the virtual plane P1 is located on the symmetrical axis (not shown) of the orthogonal projection 200a of the optical lens structure 200 on the virtual plane; i.e., the orthogonal projection 210a of the trench structure 210 on the virtual plane P1 splits the orthogonal projection 200a of the optical lens structure 200 on the virtual plane into two portions, as shown by Fig. 2B. However in other embodiments, if an asymmetrical light-radiation pattern is desired according to the requirement of a user, the orthogonal projection 210a of the trench structure 210 on the virtual plane P1 can takes an uneven layout.

In the embodiment, the trench structure 210 substantially does not expose the light emitting source 10, which means the depth D1 of the trench structure 210 is limited to an extent without exposing the light emitting source 10. The depth D1 herein is equal to a value greater than zero depending on the design of the user, as shown by Fig. 2C. In addition, the width W1 of the trench structure 210 is substantially and preferably between 0.01 mm and 1mm. In other embodiments however, the above-mentioned width W1 can vary by appropriately adjusting. In short, the above-mentioned preferred width W1 does not limit the present invention.

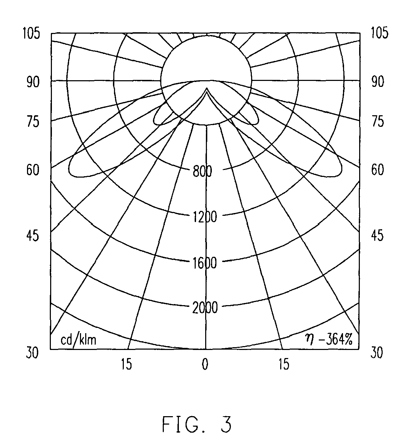

The two optical light-emitting surfaces 222 and 224 are located at both sides opposite to each other of the trench structure 210 and physically connect the trench structure 210, as shown by Figs. 2A and 2C. The illumination light 12 from the light emitting source 10 is transmitted from the optical light-emitting surfaces 222 and 224 to a direction far away from the light emitting source 10. In more details, the illumination light 12 from the light emitting source 10 disposed in the optical lens structure 200 takes, for example, an evenly-divergent light-radiation pattern. The optical lens structure 200 has the above-mentioned trench structure 210, so that the illumination light 12 from the light emitting source 20 is totally reflected by the trench structure 210 onto the optical light-emitting surfaces 222 and 224. In more details, when the illumination light 12 within the optical lens structure 200 arrives at the trench structure 210, the trench structure 210 turns the propagation direction of the illumination light 12 based on the well-known law of optical reflection. In this way, the illumination light 12 within the optical lens structure 200 is unable to be directly emitted from the trench structure 210, instead, is totally reflected or refracted onto the optical light-emitting surfaces 222 and 224. As a result, the light-radiation pattern of the light intensity distribution as shown by Fig. 3 is obtained.

It can be seen from Fig. 3, the light intensity on the middle domain (or the portion corresponding to the location of the trench structure 210) can be effectively reduced by disposing a light emitting source 10 in the above-mentioned optical lens structure 200, wherein the illumination light 12 from the light emitting source 10 is mainly distributed at both sides (for example, the optical light-emitting surfaces 222 and 224 in the embodiment) of the optical lens structure 200; from there, the major light flux is directly emitted. As a result, the design by using a light emitting source in association with the optical lens structure of the present invention can produce a better performance of light-radiation pattern in the scene illumination field.

It should be noted that the above-mentioned light emitting source 10 is, for example, a light emitting diode chip or other light sources. In addition, the material of the optical lens structure 200 of the embodiment is a transparent material, and the transparent material is, for example, polymethyl methacrylate (PMMA) or polycarbonate (PC)..

The optical lens structure 200 of the present invention can take a so-called two-off optics design methodology. For example, first, the light emitting source 10 is an one-off optics design, followed by using the optical lens structure 200 of the present invention so as to complete the above-mentioned two-off optics design, as depicted in more details as follows.

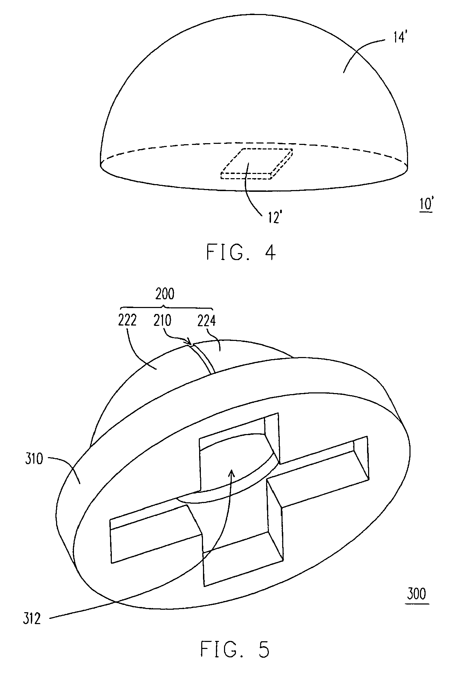

The above-mentioned light emitting source 10 can be a light emitting device 10' as shown by Fig. 4 as well, wherein the light emitting device 10' includes a LED chip 12' and an encapsulant 14'. The LED chip 12' is disposed in the encapsulant 14'. In the embodiment, the material of the encapsulant 14' is a transparent material, and the transparent material is, for example, polymethyl methacrylate or polycarbonate.. The light-radiation pattern of the light from the light emitting device 10' varies with the shape of the encapsulant 14', which is counted as the one-off optics design. Moreover, in the embodiment, the light-radiation pattern of the light from the light emitting device 10' can be the Lambert light-radiation pattern, where the light emitting diode 10' is located on the position of the light emitting source 10 of Fig. 2A, which is counted as the two-off optics design. It should be noted that the above-mentioned light emitting device 10' is disposed in the optical lens structure 200 of the present invention, but the above-mentioned two-off optics design can also have the above-mentioned advantage.

In the embodiment, an optical lens module 300 employing the above-mentioned optical lens structure 200 can be provided, ass shown by Fig. 5. In addition to the above-mentioned optical lens structure 200, the optical lens module 300 further includes a base 310 and the base 310 has an accommodation space 312. The above-mentioned light emitting source 10 or light emitting device 10' is disposed in the accommodation space 312 so as to combine the optical lens structure 200 with the light emitting source 10 or the light emittng device 10' together to achieve the same effect as described above. The related principle herein can refer the described above, which is omitted to describe.

In summary, the optical lens structure of the present invention includes a trench , which is located between two optical light-emitting surfaces. In this way, a light emitting source disposed in the optical lens structure can provide a better light-radiation pattern and the light can be emitted out from the two optical light-emitting surfaces only, so that the problem of the conventional optical lens structure that a certain extent of the light intensity distributed on the middle domain can be solved. In other words, the optical lens structure of the present invention can produce a better side-emitting light-radiation pattern to contribute a better performance in the scene illumination field

It will be apparent to those skilled in the art that various modifications and variations can be made to the structure of the present invention without departing from the scope or spirit of the invention. In view of the foregoing, it is intended that the present invention covers modifications and variations of this invention provided they fall within the scope of the following claims and their equivalents.

## Claims

1. An optical lens structure suitable to cover a light emitting source comprising:
a trench structure; and
two optical light-emitting surfaces, located at both sides opposite to each other of the trench structure and physically connecting the trench structure, wherein the illumination light from the light emitting source is transmitted from the optical light-emitting surfaces to a direction far away from the light emitting source.

2. The optical lens structure as claimed in claim 1, wherein the width of the trench structure is substantially between 0.01 mm and 1mm.

3. The optical lens structure as claimed in claim 1, wherein the illumination light from the light emitting source is total reflected by the trench structure to the optical light-emitting surfaces.

4. The optical lens structure as claimed in claim 1, wherein the trench structure substantially does not expose the light emitting source.

5. The optical lens structure as claimed in claim 1, wherein the light emitting source is a light emitting diode chip.

6. The optical lens structure as claimed in claim 1, wherein the material of the optical lens structure is a transparent material.

7. The optical lens structure as claimed in claim 6, wherein the transparent material is polymethyl methacrylate (PMMA) or polycarbonate (PC).

8. The optical lens structure as claimed in claim 1, wherein the light emitting source is a light emitting device and the light emitting device comprises:
a light emitting diode chip; and
an encapsulant, wherein the light emitting diode chip is disposed in the encapsulant.

9. The optical lens structure as claimed in claim 8, wherein the material of the encapsulant is a transparent material.

10. The optical lens structure as claimed in claim 9, wherein the transparent material is polymethyl methacrylate (PMMA) or polycarbonate (PC).
